# EUROPEAN PATENT APPLICATION

(11) **EP 4 063 337 A1**
(43) Date of publication of application: **28.09.2022**
(21) Application number: 21165200.3
(22) Date of filing: 26.03.2021
(51) Int. Cl.: C04B 35/115, B28B 1/00, C04B 35/44, C04B 35/443, C04B 35/468, C04B 35/486, C04B 35/553, C04B 35/581, C04B 35/626, C04B 35/632, C04B 35/634, C04B 35/645

(54) **MATERIAL AND PROCESS FOR FABRICATING AND SHAPING OF TRANSPARENT CERAMICS**

(71) Applicant: Glassomer GmbH, 79110 Freiburg (DE); Albert-Ludwigs-Universität Freiburg, 79098 Freiburg (DE)
(72) Inventor: RAPP, Bastian, 79100 Freiburg (DE); KOTZ, Frederik, 79232 March (DE)
(74) Representative: Müller-Boré & Partner Patentanwälte PartG mbB

(57) **Abstract**

The present invention relates to a moldable nanocomposite for producing a transparent article made of a ceramic material, the moldable nanocomposite according to the present invention comprising: an organic binder; and a powder of the ceramic material dispersed in the organic binder, the powder comprising particles having a diameter in the range from 5 nm to 700 nm, and/or a precursor of the ceramic material dispersed in the organic binder, the precursor being at least one metal-containing compound, wherein the combined content of the powder and the precursor of the ceramic material in the moldable nanocomposite is at least 5 parts per volume based on 100 parts per volume of the organic binder. Further, the present invention relates to a method of producing a transparent article made of a ceramic material, the method according to the present invention making use of the moldable nanocomposite according to the present invention.

## Description

The present invention relates to a moldable nanocomposite for producing a transparent article made of a ceramic material. Further, the present invention relates to a method of producing a transparent article made of a ceramic material.

Transparent ceramics like magnesium aluminate, also referred to as spinel, aluminum oxide, aluminum oxynitride, calcium fluoride, barium titanate, zirconia and yttrium aluminum garnet (YAG) are promising materials for the production of high-performance optics. Various processes are known in the art for fabricating and shaping of transparent ceramics, including hot pressing of particles and casting of water-based dispersions as the most important processes.

In hot pressing of particles, as described in G. Gilde et al., J. Am. Ceram. Soc. 2005, 88(10), 2747-2751, for instance, the particles are densified under high temperature and high pressure. Generally, hot pressing of particles requires flat surfaces by which the pressure can be applied. In casting of water-based dispersions, as described in A. Krell et al., J. Am. Ceram. Soc. 2003, 86(1), 12-18, for instance, the water-based dispersions are pre-densified into a powder in water, the water is evaporated, and the powder is sintered into a transparent ceramic. Generally, casting of water-based dispersions requires that the water can be removed through the pre-densified structure. As a result of the porosity induced by the water removal, inherent shrinkage and warping occur.

Accordingly, in the above processes, there are severe limitations with respect to the shape of the transparent ceramics. That is, none of the above processes can yield a transparent article made of a ceramic material, wherein the transparent article may have any desired, i.e. any freely chosen geometric form.

In view of the above, it is an object of the present invention to overcome the drawbacks associated with the processes for fabricating and shaping of transparent ceramics known in the art. In particular, the technical problem underlying the present invention is to provide means for producing a transparent article made of a ceramic material which should allow the transparent article to be obtained having a freely chosen geometric form.

The above technical problem underlying the present invention has been solved by providing the embodiments characterized in the appended claims.

Specifically, in one aspect, the above technical problem has been solved by providing a moldable nanocomposite for producing a transparent article made of a ceramic material, the moldable nanocomposite according to the present invention comprising:
an organic binder; and
a powder of the ceramic material dispersed in the organic binder, the powder comprising particles having a diameter in the range from 5 nm to 700 nm, and/or
a precursor of the ceramic material dispersed in the organic binder, the precursor being at least one metal-containing compound,
wherein the combined content of the powder and the precursor of the ceramic material in the moldable nanocomposite is at least 5 parts per volume based on 100 parts per volume of the organic binder.

Specifically, in another aspect, the above technical problem has been solved by providing a method of producing a transparent article made of a ceramic material, the method according to the present invention comprising the following steps (a) to (d):
(a) shaping the moldable nanocomposite according to the present invention into a predetermined geometric form before, during and/or after hardening of the organic binder, thereby obtaining a primary structure;
(b) debinding the primary structure obtained in step (a) by removing the organic binder, thereby obtaining a secondary structure, the secondary structure having cavities formed therein;
(c) optionally filling the cavities of the secondary structure obtained in step (b) with at least one additive; and
(d) sintering the secondary structure obtained in step (b) optionally filled with at least one additive in step (c), thereby obtaining the transparent article.

As found by the present inventors, due to the above-defined characteristics, the moldable nanocomposite according to the present invention which is used in the method according to the present invention can yield a transparent article made of a ceramic material having a freely chosen geometric form. The reason therefore lies in the organic binder having a powder and/or a precursor of the ceramic material dispersed therein. By hardening the organic binder, the moldable nanocomposite comprising the organic binder with the powder and/or the precursor of the ceramic material dispersed therein can be shaped into a predetermined geometric form, with the predetermined geometric form corresponding to the geometric form of the transparent article to be obtained.

Advantageously, as the moldable nanocomposite can be shaped into the predetermined geometric form by any suitable means known in the art, including subtractive manufacturing processes, additive manufacturing processes, replication processes, or combinations thereof, as described in more detail below, the predetermined geometric form is not further limited. Hence, the geometric form of the transparent article which is eventually obtained by debinding and sintering is not further limited, either. In other words, the geometric form of the transparent article which is made of the ceramic material originating from the powder and/or the precursor dispersed in the organic binder can be freely chosen.

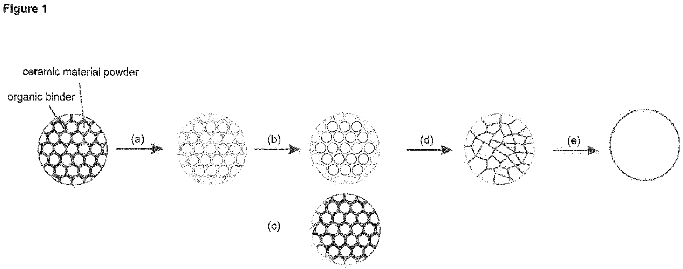

In the following, the moldable nanocomposite according to the present invention as well as the method according to the present invention are described in detail by reference to **Figure 1****,** the content of which is, however, not to be construed as limiting in any way.

According to the present invention, the nanocomposite for producing a transparent article made of a ceramic material is moldable, which means that the organic binder thereof is in or transferable to a moldable state. With the organic binder being in or transferable to a moldable state, the moldable nanocomposite can be shaped into a predetermined geometric form by hardening the organic binder, as described below in connection with the method according to the present invention.

As long as the organic binder is in or transferable to a moldable state, i.e. can be hardened, the organic binder is not further limited according to the present invention. As a result of hardening the organic binder, the primary structure obtained in step (a) maintains the predetermined geometric form into which the moldable nanocomposite has been shaped.

In one embodiment of the present invention, the organic binder is a thermoplastic which can be hardened upon cooling. Accordingly, cooling turns the softened thermoplastic into a solid so that the organic binder is no longer in a moldable state.

In case the organic binder is a thermoplastic, it may be selected from polyesters based on aromatic or aliphatic dicarboxylic acids and diols and/or hydroxycarboxylic acids, polycarbonates based on aliphatic or aromatic diols, polyolefins such as polyethylene, polypropylene, polybutene, polymethylpentene, polyisobutene, poly(ethylene-vinyl acetate), ethylene propylene rubber (EPR), poly(ethylene propylene diene), poly(vinyl butyral) (PVB), polyacrylates and polymethacrylates, cycloolefin polymers, as well as polyamides, polyacetals such as polyoxymethylene, polyethers such as polyethylene glycol (PEG), including aromatic polyethers based on bisphenols, or polyurethanes, or a combination thereof, without, however, being limited thereto.

In another embodiment of the present invention, the organic binder is a resin which can be hardened upon curing or polymerizing initiated by an external stimulus. In this context, as the external stimulus, heat or irradiation, in particular UV irradiation, may be mentioned. In some cases, mixing may be even sufficient as the external stimulus, e.g. in two-part resins, where the liquid constituents of the resin exhibit a sufficient reactivity towards each other. Further, as required, the external stimulus may include an initiator added to the organic binder for facilitating curing or polymerizing of the organic binder. Suitable initiators are known to the skilled person, such as acetophenones, e.g. 2,2-dimethoxy-2-phenylacetophenone (DMPAP), azo compounds, e.g. azobisisobutyronitrile (AIBN), benzophenone derivatives, fluorescein and its derivatives, e.g. rose bengal, quinones, e.g. camphorquinone, and phosphine derivatives, e.g. diphenyl(2,4,6-trimethylbenzoyl)phosphine oxide, without, however, being limited thereto. Accordingly, curing or polymerizing initiated by the external stimulus turns the liquid constituent(s) of the resin into a solid so that the organic binder is no longer in a moldable state. When exposed to the external stimulus, depending on the resin used, the resin is either cured which leads to a crosslinked structure or it is polymerized which leads to a non-crosslinked structure. In other words, the term "resin" as used herein not only encompasses thermosetting resins but also encompasses thermoplastic resins. That is, as the resin, any monomeric and/or oligomeric and/or polymeric composition may be mentioned herein without limitation.

In case the organic binder is a resin, it may be selected from acrylate resins and methacrylate resins, unsaturated polyester resins, vinyl ester resins, epoxy resins, thiol-ene resins, or polyurethane resins, without, however, being limited thereto. In particular, in case the organic binder is a resin, 2-hydroxyethyl methacrylate (HEMA) or a mixture of 2-hydroxyethyl methacrylate and tetraethylene glycol diacrylate (TEGDA) may be mentioned as the organic binder.

Apart from the organic binder, the moldable nanocomposite comprises a powder and/or a precursor of the ceramic material as an essential part. The powder and/or the precursor of the ceramic material are/is dispersed in the organic binder. Dispersion of the powder and/or the precursor of the ceramic material can be accomplished by any suitable means known in the art, depending on the organic binder used. In case a thermoplastic is used as the organic binder, the thermoplastic may be softened or it may be dissolved in a suitable organic solvent or gas phase before adding the powder and/or the precursor of the ceramic material thereto. In case a resin is used as the organic binder, the powder and/or the precursor of the ceramic material may be directly added to the liquid constituent(s) of the resin. Comprising both a powder of the ceramic material and a precursor of the ceramic material can lead to a higher filling level, which in turn can lead to a smaller shrinkage during sintering in step (d).

In case the moldable nanocomposite comprises a powder of the ceramic material, the powder comprises particles having a diameter in the range from 5 nm to 700 nm, preferably in the range from 7 nm to 400 nm, more preferably in the range from 20 nm to 350 nm, even more preferably in the range from 30 nm to 300 nm, and most preferably in the range from 50 nm to 250 nm. These particles are also referred to herein as the first type of particles. In addition thereto, the powder may comprise particles having a diameter in the range from 1 µm to 50 µm, preferably in the range from 2 µm to 40 µm. These particles are also referred to herein as the second type of particles. In case the powder comprises the first type of particles and the second type of particles, i.e. comprises a bimodal mixture of particles, the particles having the smaller diameter can fill the interstices between the particles having the larger diameter. Thereby, a denser packing of the particles in the moldable nanocomposite is achieved, which in turn leads to a smaller shrinkage during sintering in step (d). In principle, the powder may further comprise any other type of particles with a diameter different from that of the first type of particles and different from that of the second type of particles. Such multimodal mixtures of particles are also within the scope of the present invention.

Herein, the diameter of the first, second and any other type of particles is to be understood as the mean average diameter which is measured in accordance with ISO 9276-2. According to the present invention, the particles need not be (perfectly) spherical. That is, the particles may also be spheroidal, i.e. they may be sphere-like. For example, as regards the first type of particles with a diameter in the range from 5 nm to 700 nm, preferably in the range from 7 nm to 400 nm, more preferably in the range from 20 nm to 350 nm, even more preferably in the range from 30 nm to 300 nm, and most preferably in the range from 50 nm to 250 nm, this means that these particles may substantially have no dimension in which the diameter is smaller than 5 nm, preferably no dimension in which the diameter is smaller than 7 nm, more preferably no dimension in which the diameter is smaller than 20 nm, even more preferably no dimension in which the diameter is smaller than 30 nm, and most preferably no dimension in which the diameter is smaller than 50 nm, and substantially no dimension in which the diameter is larger than 700 nm, preferably no dimension in which the diameter is larger than 400 nm, more preferably no dimension in which the diameter is larger than 350 nm, even more preferably no dimension in which the diameter is larger than 300 nm, and most preferably no dimension in which the diameter is larger than 250 nm.

In case the moldable nanocomposite comprises a precursor of the ceramic material, the precursor is at least one metal-containing compound. Without limitation, the at least one metal-containing compound may be selected from the group consisting of organometallic compounds, metal complexes and metal salts, or may be a combination of two or more thereof. That is, the precursor of the ceramic material acts as the metal source for the ceramic material. In case the ceramic material contains only one metal, the precursor of the ceramic material is typically a single metal-containing compound. In case the ceramic material contains two or more metals, the precursor of the ceramic material is typically a mixture of two or more metal-containing compounds, wherein each metal-containing compound provides for one of the metals. Depending on the organic binder used, the precursor of the ceramic material may be dispersed therein in finely divided domains ranging from separated or complexed ions to ionic clusters as well as organometallic phases.

As mentioned above, the transparent article which is obtained from the moldable nanocomposite according to the present invention by the method according to the present invention is made of the ceramic material which originates from the powder and/or the precursor dispersed in the organic binder. According to the present invention, the ceramic material is not further limited. In particular, it may be selected depending on the intended use of the transparent article to be obtained. Without limitation, the ceramic material may be selected from the group consisting of magnesium aluminate, aluminum oxide, aluminum oxynitride, calcium fluoride, barium titanate, zirconia and yttrium aluminum garnet. In this context, the term "powder of the ceramic material", also referred to herein as ceramic material powder, means that the particles comprised in the powder are made of the ceramic material. Further, the term "precursor of the ceramic material", also referred to herein as ceramic material precursor, means that the ceramic material is formed from the at least one metal-containing compound during sintering in step (d).

According to the present invention, the combined content of the powder and the precursor of the ceramic material in the moldable nanocomposite is at least 5 parts per volume, preferably at least 30 parts per volume, more preferably at least 35 parts per volume based on 100 parts per volume of the organic binder. The higher the combined content of the powder and the precursor of the ceramic material with respect to the organic binder, the denser the packing of the ceramic material in the transparent article obtained in step (d). Surprisingly, even if the combined content of the powder and the precursor of the ceramic material with respect to the organic binder is rather high, e.g. 55 parts per volume based on 100 parts per volume of the organic binder or even more, it is still possible to shape the moldable nanocomposite into a predetermined geometric form in step (a).

Apart from the organic binder with the powder and/or the precursor of the ceramic material dispersed therein, the moldable nanocomposite may comprise one or more additional agents, as required, which facilitate the production of the transparent article to be obtained. According to the present invention, it is preferable that the content of any additional agents taken as a whole in the moldable nanocomposite does not amount to more than 30 mass-%, more preferably not more than 15 mass-%, even more preferably not more than 10 mass-%, still even more preferably not more than 5 mass-%, with the total mass of the moldable nanocomposite being 100 mass-%. That is, the moldable nanocomposite according to the present invention essentially consists of the organic binder with the powder and/or the precursor of the ceramic material dispersed therein, including any initiator added to the organic binder. Herein, the term "essentially consists of" means that the content of the organic binder with the powder and/or the precursor of the ceramic material dispersed therein, including any initiator added to the organic binder, preferably amounts to at least 70 mass-%, more preferably at least 85 mass-%, even more preferably at least 90 mass-%, still even more preferably at least 95 mass-%, with the total mass of the moldable nanocomposite being 100 mass-%.

For example, in order to facilitate dispersion of the powder and/or the precursor of the ceramic material in the organic binder, a dispersion agent may be present. As the dispersion agent, nonionic surfactants, e.g. polyoxyethylene alkyl ether or polyoxymethylene, and anionic surfactants, e.g. fatty acids and their salts or aliphatic carboxylic acids and their salts, such as stearic acid and its salts or oleic acid and its salts, may be mentioned without limitation. Another example of a dispersion agent which may be suitably used in the present invention is 2-[2-(2-methoxyethoxy)ethoxy]acetic acid. According to the present invention, it is not necessary that a dispersion agent is present. That is, the present invention also encompasses embodiments, where the moldable nanocomposite does not contain any dispersion agent.

In order to facilitate debinding of the primary structure in step (b), the moldable nanocomposite preferably further comprises a phase-forming agent dispersed in the organic binder. The phase-forming agent which is solid or viscous at room temperature, understood herein as 25 °C, forms an internal phase in the organic binder. Examples of the phase-forming agent include alcohols, ethers and silicone oils as well as combinations thereof, with these substances having a sufficiently high molecular weight and/or having appropriate functionalization so as to be solid or viscous at room temperature. Herein, the term "viscous" is to be understood as referring to a viscosity of at least 1 mPa·s at room temperature, as measured in accordance with DIN 53019. The phase-forming agent may be removed from the organic binder before or during debinding of the primary structure in step (b), e.g. by means of thermal treatment which leads to the evaporation or sublimation of the phase-forming agent, or which leads to its decomposition. Further, the phase-forming agent may be removed by means of solvent or gas phase extraction.

As a specific example, phenoxyethanol (POE) may be mentioned as the phase-forming agent. POE has a viscosity of about 30 mPa·s at room temperature, thus being a viscous substance. It can be evaporated at a temperature of 242 °C under atmospheric pressure. However, significant quantities thereof are already removed at lower temperatures due to its high vapor pressure. Further, PEG and 2-[2-(2-methoxyethoxy)ethoxy]acetic acid mentioned above may also act as the phase-forming agent.

Notably, once the primary structure has been formed, the organic binder is in a solid state (not a liquid, gel, or paste-like state). Herein, the moldable nanocomposite does not contain any thickening agent nor does it contain any low viscosity solvent like water. According to a specific embodiment of the present invention, the moldable nanocomposite neither contains triglycerides, waxes, and paraffin nor contains any plasticizer such as phthalates and any derivatives thereof.

In step (a) of the method according to the present invention, the moldable nanocomposite according to the present invention, which has been described above in detail, is shaped into a predetermined geometric form before, during and/or after hardening of the organic binder. Thereby, a primary structure, also referred to as green body, is obtained. Depending on the organic binder used, hardening is either accomplished upon cooling or upon curing or polymerizing initiated by an external stimulus. The shape of the primary structure already reflects the shape of the transparent article obtained in step (d).

Shaping of the moldable nanocomposite into the predetermined geometric form can be accomplished by any suitable means known in the art. In particular, the moldable nanocomposite may be shaped in step (a) by means of a subtractive manufacturing process, an additive manufacturing process, a replication process, or a combination thereof. Depending on the process(es) applied, the organic binder with the powder and/or the precursor of the ceramic material dispersed therein is hardened before, during and/or after shaping of the moldable nanocomposite.

In case of subtractive manufacturing processes, the organic binder with the powder and/or the precursor of the ceramic material dispersed therein is hardened before shaping of the moldable nanocomposite. In other words, the moldable nanocomposite is shaped into the predetermined geometric form after hardening of the organic binder. Suitable subtractive manufacturing processes include but are not limited to laser-based structuring techniques as well as CNC machining techniques such as milling, drilling, grinding, sawing, lathing, and polishing.

In case of additive manufacturing processes, the organic binder with the powder and/or the precursor of the ceramic material dispersed therein is hardened during shaping of the moldable nanocomposite. In other words, the moldable nanocomposite is shaped into the predetermined geometric form during hardening of the organic binder. Suitable additive manufacturing processes include but are not limited to selective laser sintering and selective laser melting, fused filament fabrication, also referred to as fused deposition modeling, stereolithography, two-photon polymerization, inkjet printing as well as volumetric printing techniques.

In case of replication processes, the organic binder with the powder and/or the precursor of the ceramic material dispersed therein is hardened after shaping of the moldable nanocomposite. In other words, the moldable nanocomposite is shaped into the predetermined geometric form before hardening of the organic binder. Suitable replication processes include but are not limited to casting, injection molding, (injection) compression molding, extrusion, thermoforming, cold or hot drawing, hot embossing, nanoimprinting as well as blow molding.

As already mentioned above, in order to shape the moldable nanocomposite into the predetermined geometric form, one or more subtractive manufacturing processes, additive manufacturing processes, and replication processes may be combined. For example, when the moldable nanocomposite is shaped by means of a replication process and the primary structure has visible artefacts resulting from said replication process, a subtractive manufacturing process may be applied to the primary structure as post-processing. Alternatively, coating techniques may be applied as post-processing in order to smoothen the surface of the primary structure obtained in step (a).

In step (b) of the method according to the present invention, the primary structure obtained in step (a) is debound by removing the organic binder. Thereby, a secondary structure, also referred to as brown body, is obtained. As a result of debinding the primary structure, i.e. removing the organic binder, the obtained secondary structure has cavities formed therein.

Depending on the organic binder used, the primary structure obtained in step (a) may be debound in step (b) by means of thermal treatment, chemical reaction, reduced pressure, solvent or gas phase extraction, or a combination thereof. For example, the primary structure may be first immersed in a solvent for carrying out solvent extraction before being thermally treated. In principle, any means may be applied which can remove the organic binder without adversely affecting the powder and/or the precursor of the ceramic material forming the secondary structure. In this context, a person skilled in the art routinely selects appropriate conditions to be applied for removing the organic binder in step (b).

For example, in case debinding is accomplished by means of thermal treatment, the temperature applied during debinding is typically in the range from 100 °C to 600 °C, e.g. in the range from 150 °C to 550 °C, the heating rate is typically in the range from 0.1 °C/min to 5 °C/min, e.g. in the range from 0.5 °C/min to 1 °C/min, and the holding time is typically in the range from 2 minutes to 12 hours, depending on the size of the transparent article to be obtained. In case the size thereof is rather small, already a few seconds may be sufficient for debinding the primary structure in step (b). Thermal treatment may also be carried out in a stepwise manner. In accordance with the above considerations, debinding by means of thermal treatment can be further facilitated by means of reduced pressure, i.e. sub-atmospheric pressure, which renders the organic binder more volatile.

In case the moldable nanocomposite comprises a powder of the ceramic material, the particles comprised in the powder adhere together due to hydrogen bonds after removal of the organic binder. Thereby, mechanical stability is imparted to the secondary structure. Taking account of the size of the particles, the diameter of which lies in the nanometer range, the particles have a high specific surface area which allows for sufficient interaction to keep the secondary structure mechanically stable. In case the moldable nanocomposite comprises a precursor of the ceramic material, the secondary structure is stabilized by the inherent cohesive forces of the at least one metal-containing compound as well as by its interaction with the particles comprised in the powder of the ceramic material, if present. As an example, an organometallic compound may interact via secondary forces such as hydrophobic interaction, van-der-Waals forces, and hydrogen bonding, while metal salts form electrostatic interactions which stabilize the secondary structure. Generally, the secondary structure obtained in step (b) has an amorphous or semicrystalline morphology.

Before the organic binder is removed in step (b), or during the removal of the organic binder, the phase-forming agent if present is removed from the primary structure, e.g. by evaporation or sublimation, or by decomposition. Removal of the phase-forming agent if present can also be accomplished by means of solvent or gas phase extraction. In principle, the same means may be applied as described above in connection with the removal of the organic binder.

As a result of removing the phase-forming agent if present, debinding of the primary structure in step (b) is facilitated. The reason therefore is that the internal phase formed by the phase-forming agent in the organic binder generates pores in the primary structure when it is removed. Through these pores, the organic binder that remains can then be removed in a more controlled manner. Thereby, the secondary structure is more easily prevented from being damaged, in particular when it adopts a thick structure. The same applies when the organic binder is removed in several steps. For example, in case the organic binder is a combination of two or more binder components exhibiting different thermal decomposition behavior, debinding may be accomplished sequentially. In this case, after having removed the first binder component, i.e. the binder component with the lowest decomposition temperature, the removal of the further binder component(s) is facilitated due to the pores generated in the primary structure after removal of the first binder component.

Debinding of the primary structure in step (b) also allows the removal of an immersed template structure that acts as a lost form within the primary structure. Once the immersed template structure which is solely composed of a material identical or chemically similar to the organic binder has been removed during debinding of the primary structure, the inverse thereof is left as a hollow structure within the obtained secondary structure. This modification is also referred to as sacrificial template replication.

In step (c) of the method according to the present invention, the cavities of the secondary structure obtained in step (b) may be filled with at least one additive. According to the present invention, step (c) is optional. The at least one additive, also referred to as filler, necessarily has a suitable size so that it can be introduced into the cavities formed in the secondary structure. Herein, the at least one additive is not further limited and may be selected as appropriate.

For example, in order to impart a specific color to the transparent article to be obtained, the at least one additive may be selected from pigments such as gold(III) chloride (AuCl₃), vanadium(III) chloride (VCl₃) and chromium(III) nitrate (Cr(NO₃)₃), for instance. Since the secondary structure is exposed to rather high temperatures when sintered in step (d) as described further below, the pigments need to withstand these temperatures. Therefore, inorganic pigments like those mentioned above are preferred compared to organic pigments which may be prone to decomposition when heated to the rather high temperatures applied during sintering.

Generally, in order to impart specific optical characteristics to the transparent article to be obtained, the at least one additive may also be selected from doping reagents which, upon decomposition during sintering in step (d), lead to a dopant such as Ag, Al, Au, B, Ti, F, Fe, Na, Ni, K, Ca, Cr, Ce, Co, Cu, Dy, Er, Eu, Gd, Ho, La, Lu, Nd, P, Pt, Pr, Pm, Rh, Sm, Sc, Tb, Tm, V, Yb, Y, Ge, Pb, Ba, Zr, Zn, and Mg, for instance. Suitable doping reagents are known to the skilled person.

Moreover, in order to increase the density of the transparent article to be obtained, the at least one additive may also be selected from a powder of the ceramic material and a precursor of the ceramic material. By filling the secondary structure with the powder and/or the precursor of the ceramic material, shrinkage of the secondary structure during sintering can be reduced. Accordingly, after sintering in step (d), the ceramic material not only originates from the powder and/or the precursor dispersed in the organic binder, but also originates from the powder and/or the precursor used as the at least one additive. In this context, the considerations as outlined above for the powder and/or the precursor of the ceramic material dispersed in the organic binder are equally applicable to the powder and/or the precursor of the ceramic material used as the at least one additive. As it is clear to the skilled person, in case a powder of the ceramic material is used as the at least one additive, the particles comprised in the powder need to have a suitable diameter, i.e. a suitable size, further to what has been outlined above.

The cavities of the secondary structure may be filled with the at least one additive in step (c) by immersing the secondary structure in a solution containing the at least one additive, exposing the secondary structure to physical or chemical vapor deposition in an atmosphere containing or generating the at least one additive, or a combination thereof. However, in principle, any other filling process may be applied in this respect as well. For example, it is also possible to apply a sol-gel process. Depending on the at least one additive with which the cavities of the secondary structure are filled in step (c), the secondary structure may be first immersed in a solution containing one of the additives, and may then be exposed to physical or chemical vapor deposition containing or generating another one of the additives. As appropriate, the cavities of the secondary structure may be filled with the at least one additive even before debinding of the primary structure is completed. In this case, it is the partially debound primary structure which is filled with the at least one additive.

In step (d) of the method according to the present invention, the secondary structure obtained in step (b) optionally filled with at least one additive in step (c) is sintered. Thereby, the transparent article is obtained.

Suitable sintering conditions are known to the skilled person and are routinely selected as appropriate. Without limitation, the temperature applied during sintering is typically in the range from 700 °C to 2000 °C, the heating rate is typically in the range from 1 °C/min to 10 °C/min, e.g. 5 °C/min, and the holding time is typically in the range from 0.5 hours to 48 hours, e.g. 4 hours, depending on the size of the transparent article to be obtained. In case the moldable nanocomposite comprises a precursor of the ceramic material dispersed in the organic binder, and/or in case a precursor of the ceramic material is used as the at least one additive, the secondary structure may be pre-sintered at an intermediate temperature in order to convert the precursor of the ceramic material into the ceramic material. For example, pre-sintering may be carried out at a temperature in the range from 400 °C to 700 °C.

After step (d), the obtained transparent article, the density of which is typically at least 90% of the theoretical density, can be cooled to room temperature and used as obtained. Herein, an article is to be understood as transparent when exhibiting an optical transmission of more than 10%, preferably more than 30%, and even more preferably more than 50% at a wavelength in the range from 400 nm to 1000 nm for a thickness of 1.0 mm. In order to achieve full densification, step (d) may include subjecting the sintered secondary structure to hot isostatic pressing (HIP). That is, when subjecting the sintered secondary structure to hot isostatic pressing, the obtained transparent article has a density of approximately 100% of the theoretical density.

Hot isostatic pressing involves the application of high temperature and high pressure in an inert gas atmosphere, e.g. in an argon atmosphere. Without limitation, the temperature applied during hot isostatic pressing is typically in the range from 1000 °C to 1800 °C, the heating rate is typically in the range from 1 °C/min to 5 °C/min, e.g. 3 °C/min, and the holding time is typically in the range from 0.5 hours to 4 hours, e.g. 2 hours, depending on the size of the transparent article obtained. The pressure applied during hot isostatic pressing is typically in the range from 100 MPa to 300 MPa, e.g. 150 MPa, without, however, being limited thereto. As a result of hot isostatic pressing, there are hardly any pores remaining within the bulk of the obtained transparent article.

As already mentioned above, the secondary structure obtained in step (b) has an amorphous or semicrystalline morphology. The same applies to the transparent article obtained in step (d). Therefore, as required, the secondary structure obtained in step (b) or the transparent article obtained in step (d) may be transformed into a single crystal. For doing so, either the secondary structure obtained in step (b) or the transparent article obtained in step (d) is exposed to an external stimulus, e.g. heat or irradiation. The transformation may be induced via abnormal grain growth, e.g. with a seed crystal. Herein, the transformation of the secondary structure obtained in step (b) or the transparent article obtained in step (d) into a single crystal is also referred to as step (e). According to the present invention, step (e) is optional.

The transparent article which is obtained from the moldable nanocomposite according to the present invention by the method according to the present invention is suitable for a variety of different applications, among others, applications in the field of optics, e.g. as a lens, taking into account that the geometrical form thereof can be freely chosen. Since any suitable means known in the art, including subtractive manufacturing processes, additive manufacturing processes, replication processes, or combinations thereof, may be applied herein, the method according to the present invention making use of the nanocomposite according to the present invention allows the production of the transparent article made of a ceramic material with both high throughput and high resolution.

### The Figures show:

**Figure 1** shows the exemplary production of a transparent article made of a ceramic material in accordance with the present invention by making reference to steps (a) to (e): (a) a primary structure is obtained from a moldable nanocomposite comprising an organic binder and a powder of the ceramic material dispersed therein; (b) a secondary structure is obtained from the primary structure, and (c) filled with at least one additive; (d) a transparent article is obtained from the secondary structure; and (e) a single crystal is obtained from the transparent article. Steps (c) and (e) are optional. Instead of using a ceramic material powder, or in addition thereto, it is possible to use a ceramic material precursor. Further, it is possible to carry out step (e) directly after step (b).
**Figure 2** shows the UV/Vis spectrum of the transparent article made of spinel as obtained after hot isostatic pressing in Example 1 described further below.
**Figure 3** shows a photograph of the transparent article made of spinel as obtained after hot isostatic pressing in Example 2 described further below.

### Examples

The present invention is further illustrated by the following Working Examples without, however, being limited thereto.

### Example 1

### Production of a transparent article made of spinel by means of casting

A moldable nanocomposite was obtained by dispersing 38 parts per volume of spinel nanopowder having a mean average diameter of 200 nm in 100 parts per volume of a mixture of 2-hydroxyethyl methacrylate (68 parts per volume) and tetraethylene glycol diacrylate (7 parts per volume) as the organic binder, and 2-[2-(2-methoxyethoxy)ethoxy]acetic acid (25 parts per volume) as the dispersion agent, which also acted as the phase-forming agent. 2,2-Dimethoxy-2-phenylacetophenone was added as the initiator for facilitating photocuring of the organic binder.

The moldable nanocomposite was cast into a polyethylene mold and the organic binder was hardened upon curing with light having a wavelength in the range from 300 nm to 400 nm, thereby obtaining a green body. The organic binder was removed from the obtained green body by thermal debinding applying the following protocol, thereby obtaining a brown body:
- heating rate: 0.5 °C/minute: 25 °C → 150 °C holding time: 4 hours
- heating rate: 0.5 °C/minute: 150 °C → 280 °C holding time: 4 hours
- heating rate: 1 °C/minute: 280 °C → 550 °C holding time: 2 hours
- cooling rate: 5 °C/minute: 550 °C → 25 °C end

The obtained brown body was sintered to reach a density of about 96% to 100% of the theoretical density applying the following protocol:
- heating rate: 5 °C/minute: 25°C → 1530 °C holding time: 4 hours
- cooling rate: 5 °C/minute: 1530 °C → 25 °C end

Full densification was accomplished by means of hot isostatic pressing under a pressure of 150 MPa in an argon atmosphere applying the following protocol:
- heating rate: 3 °C/minute: 25°C → 1700 °C holding time: 2 hours
- cooling rate: 3 °C/minute: 1700 °C → 25 °C end

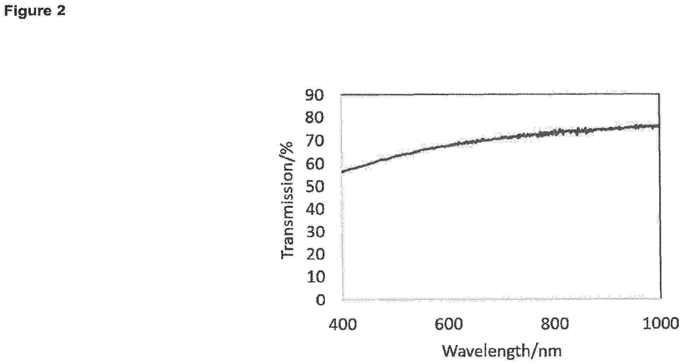

After hot isostatic pressing, a transparent article made of spinel was obtained, which had a polycrystalline morphology and exhibited an optical transmission of more than 50% at a wavelength in the range from 400 nm to 1000 nm for a thickness of 1.0 mm, as can be seen from **Figure 2****.**

### Example 2

### Production of a transparent article made of spinel by means of stereolithography

A moldable nanocomposite was obtained by dispersing 38 parts per volume of spinel nanopowder having a mean average diameter of 200 nm in 100 parts per volume of a mixture of 2-hydroxyethyl methacrylate (68 parts per volume) and tetraethylene glycol diacrylate (7 parts per volume) as the organic binder, and 2-[2-(2-methoxyethoxy)ethoxy]acetic acid (25 parts per volume) as the dispersion agent, which also acted as the phase-forming agent. 2,2-Dimethoxy-2-phenylacetophenone was added as the initiator for facilitating photocuring of the organic binder.

The moldable nanocomposite was printed using a conventional 3D printer (Asiga Pico 2 stereolithography system). During printing, the organic binder was hardened upon curing with light having a wavelength in the range from 300 nm to 400 nm as provided by a light source integrated in the printer, thereby obtaining a green body.

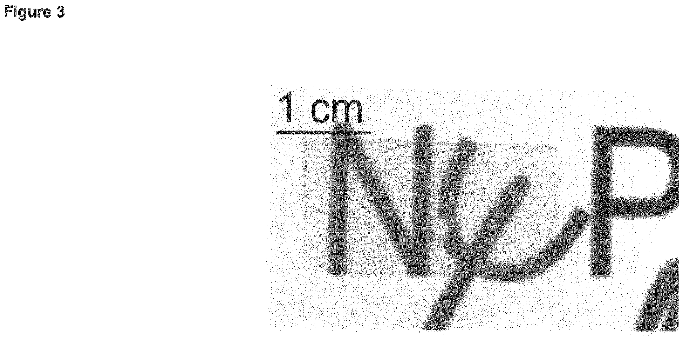

Thermal debinding, sintering and hot isostatic pressing were carried out in the same manner as outlined above in connection with Example 1, thereby obtaining a transparent article made of spinel. The transparent article made of spinel with a thickness of 1.0 mm is shown in **Figure 3****.**

### Example 3

### Production of a transparent article made of spinel by means of injection molding

A moldable nanocomposite was obtained by dispersing 38 parts per volume of spinel nanopowder having a mean average diameter of 200 nm in 100 parts per volume of a mixture of poly(vinyl butyral) (42.5 parts per volume) as the organic binder, stearic acid (15 parts per volume) as the dispersion agent, and polyethylene glycol (42.5 parts per volume) as the phase-forming agent. For dispersing the spinel nanopowder, the organic binder was heated in advance.

The moldable nanocomposite was injection-molded at 130 °C and 8 bar for 4 seconds using a microinjection molder (DSM X-Plore). The holding pressure was set to 8 bar and the mold temperature was set to 55 °C. Thereby, a green body was obtained.

Thermal debinding, sintering and hot isostatic pressing were carried out in the same manner as outlined above in connection with Example 1, thereby obtaining a transparent article made of spinel.

## Claims

1. A moldable nanocomposite for producing a transparent article made of a ceramic material, the moldable nanocomposite comprising:
an organic binder; and
a powder of the ceramic material dispersed in the organic binder, the powder comprising particles having a diameter in the range from 5 nm to 700 nm, and/or
a precursor of the ceramic material dispersed in the organic binder, the precursor being at least one metal-containing compound,
wherein the combined content of the powder and the precursor of the ceramic material in the moldable nanocomposite is at least 5 parts per volume based on 100 parts per volume of the organic binder.

2. The moldable nanocomposite according to claim 1, wherein the organic binder is a thermoplastic which can be hardened upon cooling.

3. The moldable nanocomposite according to claim 1, wherein the organic binder is a resin which can be hardened upon curing or polymerizing initiated by an external stimulus.

4. The moldable nanocomposite according to any one of claims 1 to 3, wherein the moldable nanocomposite comprises the powder of the ceramic material dispersed in the organic binder, the powder comprising particles having a diameter in the range from 1 µm to 50 µm in addition to the particles having a diameter in the range from 5 nm to 700 nm.

5. The moldable nanocomposite according to any one of claims 1 to 4, wherein the precursor of the ceramic material is at least one metal-containing compound selected from the group consisting of organometallic compounds, metal complexes and metal salts, or a combination of two or more thereof.

6. The moldable nanocomposite according to any one of claims 1 to 5, wherein the ceramic material is selected from the group consisting of magnesium aluminate, aluminum oxide, aluminum oxynitride, calcium fluoride, barium titanate, zirconia and yttrium aluminum garnet.

7. The moldable nanocomposite according to any one of claims 1 to 6, wherein the combined content of the powder and the precursor of the ceramic material in the moldable nanocomposite is at least 30 parts per volume based on 100 parts per volume of the organic binder.

8. The moldable nanocomposite according to any one of claims 1 to 7, further comprising a phase-forming agent dispersed in the organic binder.

9. A method of producing a transparent article made of a ceramic material, the method comprising the following steps (a) to (d):
(a) shaping the moldable nanocomposite according to any one of claims 1 to 8 into a predetermined geometric form before, during and/or after hardening of the organic binder, thereby obtaining a primary structure;
(b) debinding the primary structure obtained in step (a) by removing the organic binder, thereby obtaining a secondary structure, the secondary structure having cavities formed therein;
(c) optionally filling the cavities of the secondary structure obtained in step (b) with at least one additive; and
(d) sintering the secondary structure obtained in step (b) optionally filled with at least one additive in step (c), thereby obtaining the transparent article.

10. The method according to claim 9, wherein the moldable nanocomposite is shaped in step (a) by means of a subtractive manufacturing process, an additive manufacturing process, a replication process, or a combination thereof.

11. The method according to claim 9 or 10, wherein the primary structure obtained in step (a) is debound in step (b) by means of thermal treatment, chemical reaction, reduced pressure, solvent or gas phase extraction, or a combination thereof.

12. The method according to any one of claims 9 to 11, wherein the at least one additive is selected from the group consisting of a pigment, a doping reagent, a powder of the ceramic material, and a precursor of the ceramic material.

13. The method according to any one of claims 9 to 12, wherein the cavities of the secondary structure obtained in step (b) are filled with the at least one additive in step (c) by immersing the secondary structure in a solution containing the at least one additive, exposing the secondary structure to physical or chemical vapor deposition in an atmosphere containing or generating the at least one additive, or a combination thereof.

14. The method according to any one of claims 9 to 13, wherein step (d) includes subjecting the sintered secondary structure to hot isostatic pressing.

15. The method according to any one of claims 9 to 14, further comprising the following step (e):
(e) transforming the secondary structure obtained in step (b) or the transparent article obtained in step (d) into a single crystal.
